Europäisches Patentamt

European Patent Office

Office européen des brevets

(19)

(11) Publication number: 0 346 987
A1

## (12) EUROPEAN PATENT APPLICATION

(21) Application number: 89201508.2

(22) Date of filing: 12.06.89

(51) Int. Cl.⁴: H01L 21/20

(30) Priority: 17.06.88 US 208901

(43) Date of publication of application:
20.12.89 Bulletin 89/51

(84) Designated Contracting States:
DE FR GB IT NL

(71) Applicant: N.V. Philips' Gloeilampenfabrieken
Groenewoudseweg 1
NL-5621 BA Eindhoven(NL)

(72) Inventor: Martinez, André M.
c/o INT. OCTROOIBUREAU B.V. Prof.
Holstlaan 6
NL-5656 AA Eindhoven(NL)
Inventor: Pandya, Ranjana
c/o INT. OCTROOIBUREAU B.V. Prof.
Holstlaan 6
NL-5656 AA Eindhoven(NL)

(74) Representative: Rensen, Jan Geert et al
Internationaal Octrooibureau B.V. Prof.
Holstlaan 6
NL-5656 AA Eindhoven(NL)

(54) **A method of forming thin defect-free monocrystalline strips of semiconductor materials on insulators.**

(57) Method of forming monocrystalline strips of a semiconductor material on an insulator, in which parallel strips (9) of a polycrystalline or amorphous semiconductor material are formed on an insulating substrate (3, 5), the mutual distances between the strips being at least 1/4 μm. The strips (9) then are heated by means of a zone heating source (21-27) in a manner so as to form a solid-liquid interface forming an angle of at least 8° (preferably about 45°) with the strips (9), while scanning the layered structure (3, 5, 9) relative to the heating source (21-27) in a direction parallel to the strips (9). Thus monocrystalline silicon layers of distances between low angle grain boundaries larger than 300 μm can be produced.

FIG.4

## A method of forming thin defect-free monocrystalline strips of semiconductor materials on insulators.

The invention in this application relates to a method of forming thin, defect-free monocrystalline strips of semiconductor materials on insulators. The invention in this case is particularly concerned with a formation of thin monocrystalline strips of silicon on insulators, the so-called SOI structure.

It is known to produce a monocrystalline layer of silicon on an insulating structure by first depositing a thin layer of polycrystalline or amorphous silicon on an insulating substrate, for example, oxidized silicon or quartz and forming a small molten layer in the amorphous or polycrystalline silicon layer by localized heating of this layer, scanning the resultant molten zone across the silicon layer while the underlying substrate is heated. Crystallization of the molten layer of silicon causes the silicon layer to be converted to a monocrystalline layer.

Such a procedure is well known in the art as is shown for example in European patent application 0129261, Anthony, U.S. Patent 4,585,493, Cline, U.S. Patent 4,590,130, J. Sakuari, J. Electrochem Soc. Solid-State Science and Technology, pp. 1485-1488 (July 1986), C.L. Bleil et al, Mat. Res. Soc. Symp. Proc. of Vol. 35, pp. 389, 692 and Japanese Kokai 6119116. The methods described in this prior art all result in defects being formed in the resultant crystalline layer. These defects are found primarily to be due to the presence of subgrain or low angle grain boundaries and are seemed to be caused by stress on the growing crystal. Causes of this stress is considered to be from such sources as chemical impurities, surface roughness and volume expansion due to freezing and thermal gradients and different thermal expansion coefficients between substrate and Si Film.

Prior to the instant invention, the applicants thought that the use of low melting temperature glasses such as phosphosilicate glass, borophosphosilicate glass or Corning 7059 as intermediate layers underlying the recrystallizable silicon layer, as shown in the Japanese Kokai, C.L. Bleil et al and J. Sakuari, would provide a mechanism for stress relief so that the formation of low angle grain boundaries will be eliminated or significantly reduced. However, while there is some reduction of these low angle grain boundaries, the use of these substrates has not resulted in fully eliminating the formation of these boundaries.

In their copending application, Application Serial No. 084657, filed August 9, 1987, the applicants have presented a method of forming thin defect-free monocrystalline layers of semiconductor materials on insulators of significantly larger areas than formed in the aforementioned prior art.

According to the method described in this application, a thin defect-free monocrystalline layer of a semiconductor layer, particularly of silicon is formed on an insulator by the following combination of steps: a thin polycrystalline or amorphous layer of a semiconductor material is deposited on a low softening point temperature insulating substrate having a softening point of at least 10°C below the melting point of a semiconductor material with a slope of a viscosity versus temperature curve of less than 0 and greater than negative infinity. The layer of semiconductor material is then heated by a zone heating source in such a manner as to provide a convex solid-liquid interface on the layer of the semiconductor material while the layered structure is scanned (moved) relative to the zone heating source while the substrate is heated at its annealing point and the scanning speed of the structure relative to the zone heating source is controlled in such a manner as to cause the convex solid-liquid interface to move along the layer of the semiconductor material while the surface of the substrate opposing the layer of the semiconductor material is liquified under the solid-liquid interface. By this method the distance between the low angle grain boundaries in the resulting recrystallized layer is significantly increased. As a result defect-free monocrystalline silicon layers of around three hundred microns in width and several millimeters in length have been produced.

However, this method suffers from the deficiency of being complex and relatively expensive as it requires the use of two carefully focussed lamps and is relatively difficult to control.

### SUMMARY OF THE INVENTION.

An object of the instant invention is to provide a method for forming thin, defect-free monocrystalline layers of semiconductor materials on insulators of at least as large an area as shown produced by the method of the aforementioned application while employing a less expensive and less complicated method.

Other objects of the invention are apparent from the description that follows.

According to the invention, the applicants have developed a novel and simpler method of forming thin defect-free monocrystalline strips of a semiconductor material on an insulator.

The novel method of the invention involves the combination of (a) forming a layered structure by depositing a thin polycrystalline or amorphous layer of a semiconductor material on a low-softening point temperature insulating substrate, which insulating substrate has a softening point of at least 10°C below the softening point of the semiconductor material with a viscosity versus temperature curve with a slope of less than zero and greater than negative infinity; (b) removing essentially rectangular, parallel positioned longitudinal strips of widths of at least 1/4 μm of said layer of semiconductor material so as to form essentially parallel rectangular strips of the semiconductor material on the low softening point temperature insulating substrate; c) heating the strips of semiconductor material by means of a zone heating source in a manner so as to form a solid-liquid interface in the plane of said strips a line forming an angle of at least 8° with the axis of the strips while heating the substrate at its annealing point as the layered structure is scanned (moved) relative to the zone heating source; and d) controlling the scanning speed of the layered structure relative to the zone heating source in order to cause the solid-liquid interface to move along the strips of the semiconductor material in such a manner that the surface of the substrate opposing the solid-liquid interface is liquified.

The instant method has the advantages of significantly increasing the distance between low angle grain boundaries in a resulting crystallized layer to an even larger extent than achieved by the method of applicant's copending application while significantly decreasing the cost and complexity of the apparatus employed.

By use of the instant method monocrystalline silicon layers of distances between low angle grain boundaries of around 300 μm have frequently been produced and even as much as 1/2 mm have been produced.

It should be noted that in Japanese Patent applications 61-245517, and 58-39012 and United States Patent 4,497,683 there is shown recrystalization of thin polycrystalline silicon layers by monocrystalline layers by scanning with beams inclined at acute angles to the polycrystalline layers. However, unlike the present method where seeding is produced by the leading edge of the solid-liquid interface, in these references seeding is provided by a layer of monocrystalline silicon with which the polycrystalline silicon layer is at least partially in contact.

As in the copening application, it should be noted that the term "softening point" of a material having a softening range is by convention defined as the temperature at which its viscosity is $1 \times 10^7$ poises.

## BRIEF DESCRIPTION OF THE DRAWING.

In the drawing,

Fig. 1 is a cross-sectional view of a layered structure employed in one stage of the method of the invention;

Fig. 2 is a diagrammatic view of the layered structure of Fig. 1 after the formation of the strips;

Fig. 3 is a diagrammatic view of the formation of the molten zones during the method of the invention;

Fig. 4 is a diagrammatic view of a zone heating source suitable for use in the method of the invention.

## DETAILED DESCRIPTION OF THE INVENTION.

While the instant invention is useful for forming thin, defect-free monocrystalline layers of semiconductor materials in general such as Ge, ZnSe and InSb, it is particularly useful for forming defect-free monocrystalline layers of silicon on insulated base.

Although there are many materials that meet the requirement of the invention that may be used as insulators, it is preferred that the materials employed have in addition to meeting these requirements linear expansion coefficients compatible with that of the semiconductor material. When the material to be recrystallized is silicon it is useful to employ soft glasses such as phosphosilicate glass and borophosphosilicate glass, NA-40 (an aluminosilicate glass produced by the Hoya Company), 7059 glass produced by the Corning Company and spin-on glass. While any of these glasses may be employed by themselves as a supporting member for a silicon layer the glass also may be employed as a thin layer applied to a chemically inert substrate such as for example quartz, silicon or aluminum oxide.

The layer of the semiconductor material is preferably deposited by low pressure chemical vapor deposition (LPCVD). However, other suitable methods amployed in the art, such as sputtering, may also be employed. When silicon is the semiconductor material it is applied generally at a thickness of less than 10 μm. However, a thickness of 2000 Å - 10 μm is preferred.

Other semiconductor materials may be employed in similar thicknesses.

The strips of the semiconductor material may be formed by any suitable means, for example by photoetching. The strips of semiconductor material used in the invention are about 100 μm - 1000 μm wide and about 800 μm - 20 mm long.

While the method of the invention may be carried out when the zone heating source is focussed on strips so as to form a solid-liquid interface in the plane of the strips and forming an angle of at least 8° with the axis of the strips, best results are achieved when the solid liquid interface forms an angle of 10 - 80°, preferably about 45° with the major axis of the strips.

Optimum results have been found when the layered structure is also scanned relative to the zone heating source at a rate of about 16 μm/sec-6mm/sec.

The invention will now be described in greater detail with reference to the figures of the drawing which are not to scale and following example:

Example 1

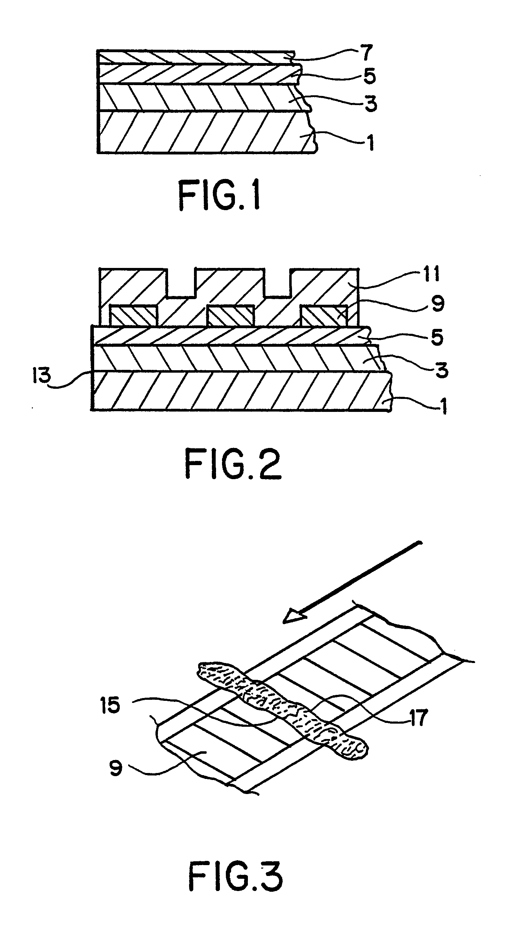

As shown in Fig. 1 of the drawing, the following layers were deposited in sequence on a 4-inch diameter silicon wafer 1, a 5.0 μm thick layer of phosphosilicate glass (PSG) 3, by low temperature chemical vapor deposition, a 1.0 μm layer of a low-temperature silicon oxide (LTO) 5 and a 1.0 μm layer of polycrystalline silicon (polysilicon) 7.

The polysilicon layer was then provided with a positive photoresist layer (not shown) such as Kodak 1470 by spin coating. The photoresist layer was then post baked to remove the solvent. The photoresist layer was then exposed to ultraviolet light through a mask so constructed as to provide alternate parallel rectangular exposed and unexposed areas in the photoresist layer, the width of the unexposed areas being about 300 μm and that the steps of photoresist are then removed with a developer such as KTI 312. The wafer was then etched in a CF₄ plasma thus removing polysilicon 7 in areas left uncovered by photoresist, while the polysilicon 7 remains in areas covered by the photoresist. Essentially, rectangular parallel 300 μm wide strips of polysilicon 9 separated from each other by 100 μm were thus formed on the LTO layer 5.

The remaining photoresist is removed by acetone and then a 1.5 μm thick capping layer of LTO 11 was deposited on the polysilicon strips 9.

The resultant layered assembly 13 a cross-sectional view of which is shown in Fig. 2, was then heated to about 1000°C-1020°C, to the annealing point of the phosphosilicate glass layer 3 by a graphite resistance heater, not shown.

While being heated in this manner the layered assembly 13 was moved (scanned) in a linear direction at a speed of about 1.00 mm per second parallel to the polysilicon strips and past a zone heating system providing a spot of an elliptical cross-section focussed in such a manner on the plane of the polysilicon strips 9 so as to form a molten zone 15 about 3 mm long and having an elliptical cross-section having a solid-liquid interface 17 approximating a straight line angled at about 45° relative to the major axis of the polysilicon strips 9 as shown in cross-section in Fig. 3.

While being scanned by the zone heating system in this manner heat conducted from the molten zone 15 of a polysilicon strip 9 found a molten zone in the phosphosilicate glass layer 3 coinciding with the molten zone 15 in the polysilicon strip 9.

By this means the polysilicon strips 9 were converted into 3 mm long by 300 μm wide monocrystalline silicon strips showing no detectable subboundaries, twins or threading dislocations.

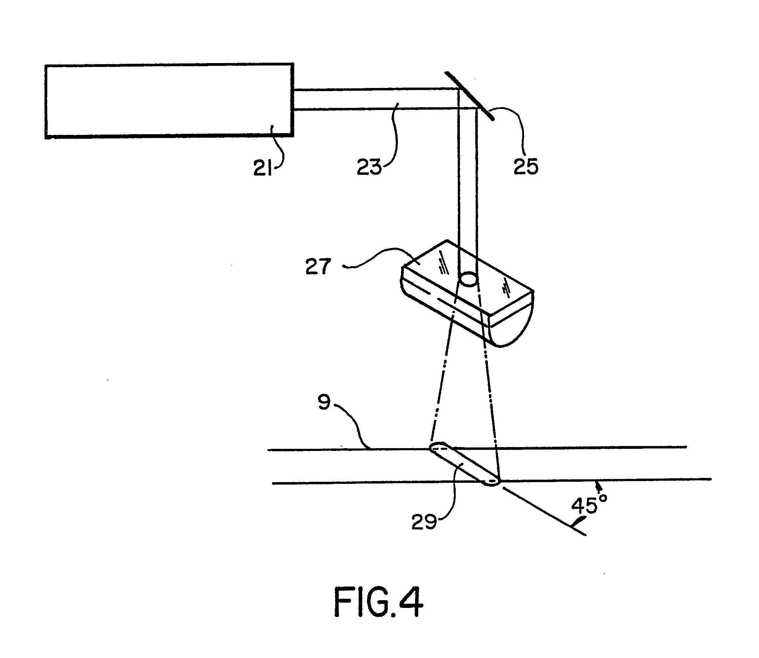

A suitable zone heating system is shown schematically in Fig. 4.

As shown in Fig. 4 a laser beam 23 having a diameter of 6.3 mm from a 50 watt CO₂ laser 21 is directed by plane mirror 25 into a cylindrical lens 27, the focal length of which is 121 mm, and arranged so that the major axis of the spot is positioned at 45° relative to the polysilicon strips 9 thereby focussing the beam 23 to an elliptical spot 29 in the plane of the polysilicon strips 9, the major axis of which spot, is angled at 45° with the strips 9.

**Claims**

1. A method of forming thin defect-free monocrystalline strips of a semiconductor material on an insulator, said method comprising:

a) depositing a thin polycrystalline or amorphous layer of a semiconductor material on an insulating substrate, having a softening point of at least 10°C below the melting point of the semiconductor material and a slope of its viscosity versus temperature curve of less than zero and greater than negative infinity;

b) removing essntially rectangular parallel-positioned strips of widths of at least 1/4 μm from said layer of semiconductive material so as to form essentially parallel rectangular strips of said semiconductor material on the low-softening point insulating substrate;

c) heating said strips of semiconductor material by means of a zone heating source the heat of which is focussed on said strips in a manner so as to form a solid-liquid interface along the plane of said strips and forming an angle of at least 8° with the axis of said strips while heating said substrate at its anneaking point and while scanning the resultant layered structure relative to said zone heating source in a direction parallel to the major axis of said strips; and

d) controlling the scanning speed of said layered structure relative to the zone heating source so as to cause the solid-liquid interface to move along the strips in such a manner that the surface of the substrate opposing the solid-liquid interface is liquified.

2. The method of Claim 1 wherein the semiconductor material is amorphous silicon or polycrystalline silicon.

3. The method of Claim 2 wherein the solid-liquid interface forms an angle of 10-80° with the major axis of said strips.

4. The method of Claim 3 wherein the width of the strips of semiconductor material formed on the insulating substrate is about 100 μm - 1000 μm wide.

5. The method of Claim 4 wherein the layered structure is scanned relative to the zone heating source at a rate of 16 μm/sec -6 mm/sec.

6. The method of Claim 5 wherein the low-softening point temperature insulating substrate is a glass selected from the group consisting of phosphosilicate glass, borosilicate glass, aluminosilicate and spin-on-glass.

7. The method of Claim 4 wherein the low-softening point insulating substrate is a thin layer supported at its surface opposite to that of the silicon layer by a chemically inert substrate.

8. The method of Claim 7 wherein the chemically inert substrate is oxidized silicon or quartz.

9. The method of Claim 4 wherein both surfaces of the thin silicon layer are provided with a low temperature chemical vapor deposited coating of silicon dioxide.

10. The method of Claim 6 wherein both surfaces of the thin silicon layer are provided with a low temperature vapor deposited coating of silicon dioxide.

11. The method of Claim 8 wherein both surfaces of the thin silicon layer are provided with a low temperature vapor deposited coating of silicon dioxide.

12. The method of Claim 9 wherein the silicon layer is less than 10 microns thick.

13. The method of Claim 12 wherein the thin silicon layer is 2000Å - 10 μm thick.

14. The method of Claim 13 wherein the thin silicon layer is chemically vapor deposited.

15. The method of Claim 10 wherein the thin silicon layer is less than 10 microns thick.

16. The method of Claim 10 wherein the thin silicon layer is 2000 Å - 16 μm thick.

17. The method of Claim 16 wherein the thin silicon layer is chemically vapor deposited.

18. The method of Claim 3 wherein the strips are 800 μm-20mm long.

19. The method of Claim 3 wherein the solid-liquid interface forms an angle of about 45° with the axis of said strips.

FIG.1

FIG.2

FIG.3

FIG.4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 743 567 (PANDYA et al.)<br>* Whole document *<br>--- | 1,2,5-17 | H 01 L 21/20 |
| A | APPLIED PHYSICS LETTERS, vol. 52, no. 11, 14th March 1988, pages 901-903, American Institute of Physics, New York, NY, US; R. PANDYA et al.: "Large-area-defect-free silicon-on-insulator films by zone-melt recrystallization"<br>* Abstract; page 901, column 1, lines 24-47; page 902, column 2, lines 15-33 *<br>--- | 1,2,5-17 | |
| A | PATENT ABSTRACTS OF JAPAN, vol. 9, no. 189 (E-333) 6th August 1985, page 113 E 333; & JP-A-60 58 611 (SONY K.K.) 04-04-1985<br>* Abstract *<br>--- | 1-4,18, 19 | |
| A | US-A-4 046 618 (P. CHAUDHARI et al.)<br>--- | | TECHNICAL FIELDS SEARCHED (Int. Cl.4) |
| A | LASER AND ELECTRON-BEAM SOLID INTERACTIONS AND MATERIALS PROCESSING, 1981, pages 487-494, Elsevier North-Holland, Inc., Gibbons, Hess, and Sigmon, eds., Amsterdam, NL; D.K. BIEGELSEN et al.: "Laser induced crystal growth of silicon islands on amorphous substrates"<br>----- | | H 01 L |

The present search report has been drawn up for all claims

| Place of search | Date of completion of the search | Examiner |
|---|---|---|
| THE HAGUE | 31-08-1989 | GELEBART Y.C.M. |